# FASCICULE DE BREVET EUROPEEN

(11) **EP 3 951 512 B1**
(45) Date de publication et mention de la délivrance du brevet: **01.03.2023**
(21) Numéro de dépôt: 20189291.6
(22) Date de dépôt: 04.08.2020
(51) Int. Cl.: G04B 45/00

(54) **PROCEDE DE FABRICATION D'UNE PIECE COMPRENANT AU MOINS UN MOTIF METALLISE EN TROIS DIMENSIONS**
VERFAHREN ZUR HERSTELLUNG EINES WERKSTÜCKS MIT MINDESTENS EINEM METALLISIERTEN 3D-MOTIV
METHOD FOR MANUFACTURING A PART COMPRISING AT LEAST ONE THREE-DIMENSIONAL METALLISED PATTERN

(43) Date de publication de la demande: 09.02.2022
(73) Titulaire: Comadur S.A., 2400 Le Locle (CH)
(72) Inventeur: LINTYMER, Jan, 25000 Mamirolle (FR); LE BOUDOUIL, M. Damien, 25500 Morteau (FR); BAICHETTE, Benoit, 2000 Neuchâtel (CH)
(74) Mandataire: ICB SA

(56) Documents cités:
- EP-A1- 0 453 382
- EP-A1- 3 035 129
- EP-A1- 3 246 766
- EP-B1- 0 453 382
- EP-B1- 3 035 129
- WO-A1-2018/114205

## Description

### Domaine technique

L'invention concerne un procédé de fabrication d'une pièce comprenant au moins un motif métallisé en trois dimensions surplombant une sous-couche locale d'émail.

L'invention concerne également une pièce fabriquée via un tel procédé de fabrication. Une telle pièce peut en particulier être un composant décoré d'une pièce d'habillage horloger ou d'une pièce de bijouterie.

### Arrière-plan technologique

Il est connu de réaliser des composants décorés pour pièces d'habillage horloger ou pour pièces de bijouterie. Par exemple, de tels composants décorés peuvent consister en l'incrustation de motifs esthétiques sur une partie d'une montre. Il peut s'agir d'une lunette de montre décorée de motifs tels que des indices ; ou bien d'un cadran de montre décoré avec un index ; ou encore d'une couronne, d'une glace ou d'une carrure de la montre, décorée avec un ou plusieurs motifs, ou encore de maillons de bracelet. La partie de montre concernée par le décor peut être marquée, par exemple au moyen d'un métal tel que de l'or, de l'argent ou du platine, avec un marquage en relief ou en profondeur. S'il s'agit d'un marquage en profondeur, ce dernier est par exemple réalisé par remplissage de creux préalablement formés dans un substrat ou support de base de la partie de montre.

Le principe utilisé pour la réalisation d'un tel marquage en profondeur consiste à déposer tout d'abord une couche conductrice par dépôt physique en phase vapeur PVD (de l'anglais Physical Vapor Déposition). Une fois la couche conductrice déposée, les creux sont remplis d'un métal par électroformage en plongeant la pièce dans un bain à ions métalliques, puis un courant électrique est mis en circulation dans ce bain. Ainsi les creux se remplissent de métal pour réaliser le marquage. On peut citer à ce titre le document brevet EP 2 138 323 A1 qui décrit un tel procédé. Cependant un tel procédé est complexe et relativement lent à mettre en oeuvre pour réaliser le composant décoratif sur la pièce d'habillage horloger, car il nécessite plusieurs étapes de réalisation, ce qui constitue un inconvénient. De plus, un autre inconvénient d'un tel procédé est qu'il fonctionne par dépôt de couches minces uniquement, ce qui ne permet pas de réaliser des motifs décoratifs en trois dimensions satisfaisants sur la pièce d'habillage horloger.

Il est par ailleurs connu des procédés de réalisation de composants décorés pour pièces d'horlogerie, mettant en oeuvre une croissance galvanique ou galvanoplastie. Un tel procédé est par exemple décrit dans le document brevet EP 3 035 128 A1. Le procédé de fabrication décrit dans ce document comprend les étapes consistant à fournir un substrat de base en silicium et à réaliser un micro-usinage dans ce substrat de base de sorte à obtenir une partie supérieure munie d'un décor traversant l'épaisseur de cette partie. Cette étape de micro-usinage comprend les phases consistant à déposer sur une couche conductrice supérieure du substrat de base une couche de résine photosensible ; à placer ensuite sur la résine photosensible un masque au contour de la partie supérieure et du motif du décor à réaliser ; puis à exposer la résine à un rayonnement à travers le masque, de manière à développer certaines parties de la résine ; à enlever ensuite les parties de résine non développées et à remplir les parties ainsi ouvertes de la résine avec un matériau métallique ; à réaliser une opération de galvanoplastie ou électrodéposition mettant en oeuvre une croissance du matériau métallique ; et enfin à retirer toute la résine et à détacher la partie supérieure avec le motif du décor réalisé du substrat de base. Toutefois, un inconvénient d'un tel procédé est qu'il ne permet pas de réaliser facilement des formes précises et maitrisées en trois dimensions pour les décors. Ainsi, un tel procédé ne permet pas de réaliser de manière nette et maitrisée des motifs décoratifs en trois dimensions sur la pièce d'habillage horloger.

### Résumé de l'invention

L'invention a donc pour but de proposer un procédé de fabrication d'une pièce permettant de réaliser facilement des motifs décoratifs métallisés en trois dimensions sur la pièce, et d'obtenir des motifs pouvant présenter des formes complexes, précises et maitrisées.

A cet effet, l'invention concerne un procédé de fabrication d'une pièce comprenant au moins un motif métallisé en trois dimensions surplombant une sous-couche locale d'émail, qui comprend les caractéristiques mentionnées dans la revendication indépendante 1.

Des formes particulières du procédé de fabrication sont définies dans les revendications dépendantes 2 à 17.

Le procédé de fabrication selon l'invention permet, grâce à la formation préalable en trois dimensions sur le substrat d'un ou plusieurs motif(s) en émail puis au dépôt d'une couche métallique structurée sur ces motifs, de pouvoir réaliser facilement des motifs décoratifs métallisés en trois dimensions sur la pièce. Les motifs décoratifs en trois dimensions ainsi réalisés sont nets, et peuvent avantageusement présenter des formes complexes, précises et maitrisées. En outre, l'utilisation d'émail métallisé présente comme avantages additionnels d'être inerte aux produits chimiques et de résister aux hautes températures, contrairement à certains matériaux utilisés dans les solutions de l'art antérieur.

Selon un mode de réalisation préférentiel de l'invention, la résine photosensible est une résine photosensible négative, les parties de la couche de résine complémentaires du ou des motif(s) en trois dimensions sont les parties non développées de la couche de résine, et les parties de résine restantes sont les parties développées de la couche de résine.

Avantageusement, l'émail de la sous-couche locale d'émail a été préalablement fritté. Ceci permet de rendre l'émail poreux et de faciliter ainsi la mise en forme en trois dimensions du ou des motif(s) en émail.

A cet effet, l'invention concerne également une pièce fabriquée via le procédé de fabrication tel que décrit ci-dessus, et qui comprend les caractéristiques mentionnées dans la revendication 15.

### Brève description des figures

Les buts, avantages et caractéristiques du procédé de fabrication d'une pièce comprenant au moins un motif métallisé en trois dimensions selon l'invention apparaîtront mieux dans la description suivante sur la base d'au moins une forme d'exécution non limitative illustrée par les dessins sur lesquels :
- la figure 1 est un organigramme représentant une succession d'étapes d'un procédé de fabrication d'une pièce comprenant au moins un motif métallisé en trois dimensions selon l'invention, le motif métallisé surplombant une sous-couche locale d'émail ; et
- la figure 2 est un organigramme représentant une succession d'étapes d'un procédé de fabrication de la sous-couche locale d'émail de la figure 1.

### Description détaillée de l'invention

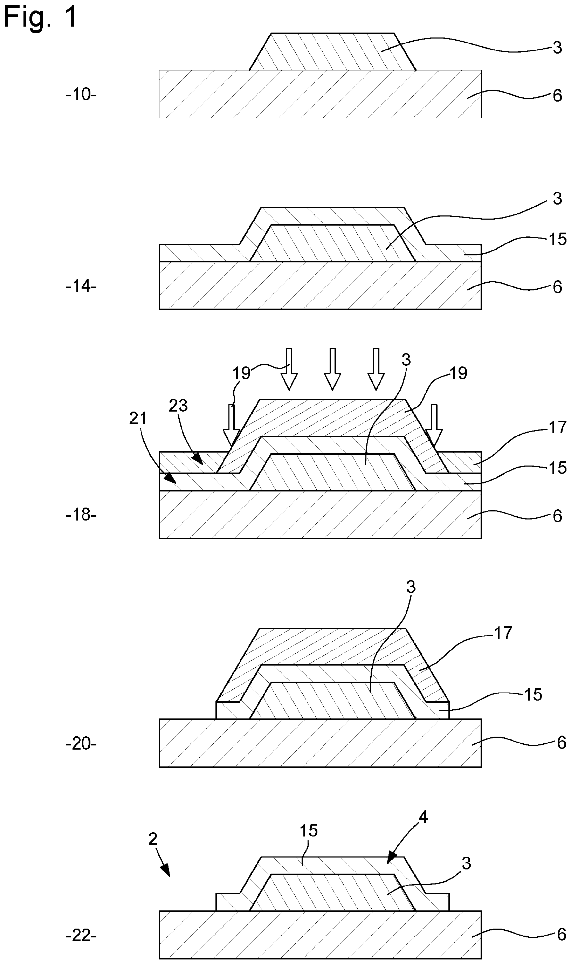

Le procédé de fabrication d'une pièce 2 comprenant au moins un motif métallisé en trois dimensions 4 selon l'invention va être décrit en référence à la figure 1. La pièce 2 est typiquement un composant décoré d'une pièce d'habillage horloger ou d'une pièce de bijouterie, tel que par exemple une lunette de montre, ou bien un cadran de montre décoré avec un index en trois dimensions, ou encore une couronne, une glace ou une carrure de la montre. Sans que cela ne soit limitatif dans le cadre de la présente invention, les motifs métallisés en trois dimensions 4 sont par exemple des indices, des index, des logos, ou encore des décorations esthétiques.

Au cours d'une étape initiale 10, un substrat 6 est fourni sur lequel sont préalablement formés, en trois dimensions, un ou plusieurs motif(s) 3 en émail. De préférence, l'émail constituant les motifs 3 est préalablement fritté.

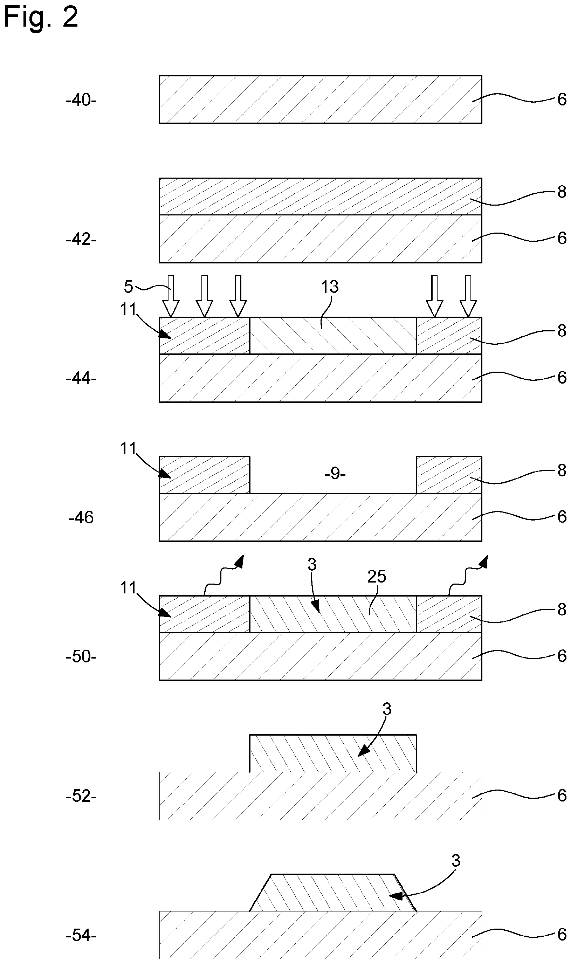

Cette sous-couche locale d'émail peut être fabriquée selon tout type de procédé de fabrication connu. En particulier, et sans que cela ne soit limitatif dans le cadre de la présente invention, un exemple d'un tel procédé va maintenant être décrit en référence à la figure 2.

Au cours d'une première étape 40, le substrat 6 nu est fourni. Le substrat 6 est constitué d'un matériau apte à résister à des hautes températures, notamment des températures pouvant aller jusqu'à 1400°C. Le substrat 6 est de préférence choisi parmi le groupe consistant en du zircon, de l'alumine, du saphir ou du rubis. Cependant il peut aussi être pris un substrat 6 semi-conducteur, tel que du silicium, voire de l'arséniure de gallium, dont une couche supérieure peut être conductrice, ou un substrat en matière naturelle telle que de la nacre.

Au cours d'une étape suivante 42, une couche de résine photosensible 8 est déposée sur la surface supérieure du substrat 6.

Au cours d'une étape suivante 44, la couche de résine photosensible 8 est exposée sélectivement à un rayonnement 5, de sorte à développer localement des parties 11 de résine 8 dans le but de former des portions vides 9 dans la résine 8. Le rayonnement 5 utilisé est par exemple un rayonnement ultra-violet (UV) émis par un laser ou une lampe UV. Pour effectuer cette structuration de la résine 8, un masque (non représenté) est appliqué sur la couche de résine 8, le contour du masque correspondant aux portions vides 9 à former. La résine photosensible 8 est par exemple une résine photosensible négative. Cette résine 8 peut être une résine photopolymérisable, par exemple une résine à base de poly-imide PMMA (poly-méthyle méthacrylate) ou une résine époxyde octofonctionnelle disponible chez Shell Chemical sous la référence SU-8 et d'un photoinitiateur choisi par exemple parmi les sels de triarylsulfonium. Le masque peut être une plaque de quartz sur laquelle est réalisée une couche de masquage avec des parties opaques et transparentes selon les portions vides 9 à réaliser. En variante, la résine photosensible 8 peut être une résine photosensible positive. Dans ce cas, le masque est l'inverse du masque utilisé avec la résine photosensible négative. A l'issue de cette étape 44 le masque est enlevé.

Au cours d'une étape suivante 46, les parties de la couche de résine 8 correspondant aux portions vides 9 à former sont enlevées. Cette étape d'enlèvement est par exemple effectuée par des moyens physiques ou chimiques. Dans le cas où une résine photosensible négative est utilisée (comme c'est le cas sur la figure 2), ce sont les parties non irradiées 13 de la résine 8 qui sont enlevées. Les parties 13 ainsi enlevées dans la résine 8 laissent alors apparaitre les portions vides 9 dans la résine 8. Inversement, dans le cas où une résine photosensible positive est utilisée (cas non représenté sur les figures), ce sont les parties irradiées de la résine qui sont enlevées. Une résine non photosensible peut aussi est utilisée, dans ce caslà cette dernière est enlevée mécaniquement via une ablation laser.

Au cours d'une étape suivante, les portions vides 9 dans la résine 8 sont remplies par une poudre d'émail 25.

Au cours d'une étape suivante 50, la poudre d'émail 25 est pré-cuite. Pour ce faire, la poudre d'émail 25 est par exemple chauffée à une température de 200°C, par exemple pendant 50 minutes. Au cours de cette même étape 50, ou au cours d'une étape suivante, les parties restantes 11 de la résine 8 sont enlevées, par exemple thermiquement. Pour ce faire, les parties restantes 11 de la résine 8 sont par exemple chauffées à une température de 600°C, par exemple pendant 30 minutes. Cet enlèvement des dernières parties 11 de résine 8 restantes permet de faire apparaitre le ou les motif(s) 3 en émail, au niveau des zones correspondant aux portions vides 9 de résine précédentes.

De préférence, au cours d'une étape suivante 52, l'ensemble formé du substrat 6 et du ou des motif(s) 3 en émail est nettoyé.

De préférence, au cours d'une étape finale 54, l'émail du ou des motif(s) 3 est fritté, ce qui permet de faciliter la mise en forme en trois dimensions du ou des motif(s) 3 en émail et de faciliter l'adhésion de la couche métallique.

L'exemple de procédé de fabrication de la sous-couche locale d'émail formant les motifs 3 représenté à la figure 2 présente l'avantage de ne pas nécessiter d'outillage complexe, et d'être relativement simple à mettre en oeuvre et peu onéreux.

Un autre exemple de procédé de fabrication de la sous-couche locale d'émail formant les motifs 3, non représenté sur les figures, consiste à appliquer directement l'émail sur le substrat par tampographie, au cours d'une ou de plusieurs étapes initiales. L'émail est ensuite pré-cuit au cours d'une étape suivante. Pour ce faire, l'émail est par exemple chauffé à une température de 177°C, par exemple pendant 60 minutes. De préférence, au cours d'une étape suivante, l'émail du ou des motif(s) est fritté. Pour ce faire, l'émail est par exemple fritté à une température de 860°C, par exemple pendant 5 minutes. Cette étape de frittage permet de définir les formes souhaitées dans l'émail et de faire ainsi apparaitre le ou les motif(s) en émail. De préférence, au cours d'une étape finale, l'ensemble formé du substrat et du ou des motif(s) en émail est nettoyé. Cet exemple de réalisation particulier du procédé de fabrication de la sous-couche locale d'émail présente l'avantage de ne pas nécessiter d'effectuer de quelconque structuration sur une résine photosensible.

En revenant au procédé de fabrication selon l'invention, tel qu'illustré à la figure 1, le ou les motif(s) en émail 3 sont nettoyés au cours d'une étape préférentielle suivante.

Au cours d'une étape suivante 14, au moins une couche de métallisation 15 est déposée sur le ou les motif(s) en émail 3. De préférence, comme illustré sur la figure 1, la couche de métallisation 15 recouvre complètement le ou les motif(s) en émail 3 à l'issue de cette étape de dépôt 14. De préférence encore, le matériau de métallisation utilisé au cours de cette étape de dépôt 14 est du nitrure de chrome, de l'oxynitrure de zirconium, ou encore de l'or. Bien évidemment, l'étape de métallisation peut consister en un empilement de plusieurs couches métalliques.

Au cours d'une étape suivante, une couche de résine photosensible 17 est déposée sur la couche de métallisation 15. De préférence, comme illustré sur la figure 1, la couche de résine photosensible 17 recouvre complètement la couche de métallisation 15 à l'issue de cette étape de dépôt.

Au cours d'une étape suivante 18, la couche de résine photosensible 17 est exposée sélectivement à un rayonnement 7, de sorte à développer localement des parties 19 de résine. Ces parties 19 de résine correspondent à, au ou aux motif(s) en trois dimensions. Le rayonnement 7 utilisé est par exemple un rayonnement ultra-violet (UV) émis par une lampe. Pour effectuer cette structuration de la résine 17, un masque (non représenté) est appliqué au-dessus de la couche de résine 17, le masque correspondant au(x) motif(s) en trois dimensions. La résine photosensible 17est par exemple une résine photosensible négative. Cette résine 17 peut être une résine photopolymérisable, par exemple une résine à base de poly-imide PMMA (poly-méthyle méthacrylate) ou une résine époxyde octofonctionnelle disponible chez Shell Chemical sous la référence SU-8 et d'un photoinitiateur choisi par exemple parmi les sels de triarylsulfonium. Le masque peut être une plaque de quartz sur laquelle est réalisée une couche de masquage avec des parties opaques et transparentes. En variante, la résine photosensible 8 peut être une résine photosensible positive. Dans ce cas, le masque est l'inverse du masque utilisé avec la résine photosensible négative. A l'issue de cette étape 18 le masque est enlevé.

Selon un autre mode de réalisation, une résine non photosensible est utilisée, une fois la résine sèche, cette dernière est enlevée mécaniquement via une ablation au laser et ne nécessite donc pas de masque.

Au cours d'une étape suivante 20, les parties de la couche de résine 17 complémentaires du ou des motif(s) sont enlevées. Cette étape d'enlèvement 20 est par exemple effectuée par des moyens physiques ou chimiques. Au cours de cette même étape 20, les parties sous-jacentes correspondantes 21 de la couche de métallisation 15 sont enlevées également. De préférence, les parties sous-jacentes 21 de la couche de métallisation 15, qui correspondent aux parties de la couche de résine 17 complémentaires du ou des motif(s), sont enlevées par attaque chimique (aussi appelée gravage). Dans le cas où une résine photosensible négative est utilisée (comme c'est le cas sur la figure 1), ce sont les parties non irradiées 23 de la résine 17 qui forment les parties complémentaires du ou des motif(s) et qui sont enlevées au cours de cette étape 20. Les parties 19 de résine développées localement (donc irradiées) correspondent alors au(x) motif(s). Inversement, dans le cas où une résine photosensible positive est utilisée (cas non représenté sur les figures), ce sont les parties irradiées de la résine qui forment les parties complémentaires du ou des motif(s) et qui sont enlevées. Les parties de résine non irradiées sont correspondent alors au(x) motif(s).

Au cours d'une étape suivante 22, les parties restantes de la résine 17, correspondant au(x) motifs, sont enlevées. Cette étape 22 est par exemple effectuée au moyen d'un solvant. Ceci permet de laisser apparaitre le ou les motif(s) métallisé(s) en trois dimensions 4. Chaque motif 4 est alors constitué du matériau de métallisation 15 déposé sur une sous-couche locale d'émail 3. Dans le cas où une résine photosensible négative est utilisée (comme c'est le cas sur la figure 1), ce sont les parties développées 19 de la résine 17 qui forment les parties restantes et qui sont enlevées au cours de cette étape 22. Inversement, dans le cas où une résine photosensible positive est utilisée (cas non représenté sur les figures), ce sont les parties non développées de la résine qui forment les parties restantes et qui sont enlevées au cours de cette étape 22.

De préférence, au cours d'une étape finale, la pièce 2 est nettoyée.

On comprend ainsi que le procédé de fabrication selon l'invention permet de réaliser facilement des motifs décoratifs métallisés en trois dimensions 4 sur la pièce 2. Les motifs décoratifs en trois dimensions 4 ainsi réalisés sont nets, et peuvent avantageusement présenter des formes complexes, précises et maitrisées.

## Revendications

1. Procédé de fabrication d'une pièce (2) comprenant au moins un motif métallisé en trois dimensions (4) surplombant une sous-couche locale d'émail (3) ; le procédé comprenant les étapes consistant à :
- fournir (10) un substrat (6) sur lequel sont préalablement formés en trois dimensions un ou plusieurs motif(s) en émail (3) ;
- déposer (14) au moins une couche de métallisation (15) sur le ou les motif(s) en émail (3) ;
- déposer une couche de résine (17) sur la couche de métallisation (15) ;
- travailler sélectivement (18) la couche de résine (17), de sorte à former localement des parties de résine (19) correspondant à ou complémentaires du ou des motif(s) en trois dimensions ;
- enlever (20) les parties (23) de la couche de résine complémentaires du ou des motif(s) en trois dimensions, ainsi que les parties sous-jacentes (21) correspondantes de la couche de métallisation (15) ; et
- enlever les parties de résine restantes (19), de sorte à laisser apparaitre le ou les motif(s) métallisé(s) en trois dimensions (4) correspondant(s), le ou chaque motif (4) étant constitué du matériau de métallisation déposé sur une sous-couche locale d'émail (3).

2. Procédé selon la revendication 1, **caractérisé en ce que** la résine (17) est une résine photosensible négative ou positive, **en ce que** les parties (23) de la couche de résine complémentaires du ou des motif(s) en trois dimensions sont les parties non développées ou développée de la couche de résine (17), et **en ce que** les parties de résine restantes (19) sont les parties développées ou non développées de la couche de résine (17).

3. Procédé selon la revendication 1 ou 2, **caractérisé en ce que** l'émail de la sous-couche locale d'émail (3) a été préalablement fritté.

4. Procédé selon l'une quelconque des revendications précédentes, **caractérisé en ce qu'**il comprend en outre, avant l'étape (14) de dépôt d'une couche de métallisation (15), une étape de nettoyage du ou des motif(s) en émail (3).

5. Procédé selon l'une quelconque des revendications précédentes, **caractérisé en ce que** les parties de résine restantes (19) sont enlevées au moyen d'un solvant.

6. Procédé selon l'une quelconque des revendications précédentes, **caractérisé en ce qu'**il comprend en outre une étape finale de nettoyage de la pièce (2).

7. Procédé selon l'une quelconque des revendications précédentes, **caractérisé en ce que** le matériau de métallisation (15) est du nitrure de chrome, oxynitrure de zirconium, or ou titane.

8. Procédé selon l'une quelconque des revendications précédentes, **caractérisé en ce que** la résine photosensible (17) est une résine photopolymérisable telle qu'une résine époxyde photopolymérisable, de préférence une résine à base d'époxyde octofonctionnelle SU-8.

9. Procédé selon l'une quelconque des revendications 1 à 7, **caractérisé en ce que** la résine (17) non photosensible est une résine à base d'epoxy.

10. Procédé selon l'une quelconque des revendications 1 à 8, **caractérisé en ce que** l'étape (18) de travail sélectif de la couche de résine (17) photosensible est effectuée au moyen d'une lampe UV, et comprend une phase initiale d'application d'un masque sur la couche de résine (17), le contour du masque correspondant audit ou auxdits motif(s) en trois dimensions.

11. Procédé selon l'une quelconque des revendications 1 à 7 et 9, **caractérisé en ce que** l'étape (18) de travail sélectif de la couche de résine (17) non photosensible est effectuée au moyen d'une ablation au laser.

12. Procédé selon l'une quelconque des revendications précédentes, **caractérisé en ce que** les parties (21) de la couche de métallisation (15) sous-jacentes aux parties (23) de la couche de résine complémentaires du ou des motif(s) en trois dimensions sont enlevées par attaque chimique.

13. Procédé selon l'une quelconque des revendications précédentes, **caractérisé en ce que**, à l'issue de l'étape (14) de dépôt de la couche de métallisation (15), la couche de métallisation (15) recouvre complètement le ou les motif(s) en émail (3).

14. Procédé selon l'une quelconque des revendications précédentes, **caractérisé en ce que**, à l'issue de l'étape de dépôt de la couche de résine (17), la résine (17) recouvre complètement la couche de métallisation (15).

15. Procédé selon l'une quelconque des revendications précédentes, **caractérisé en ce que** le substrat (6) est constitué d'un matériau apte à résister à des températures pouvant aller jusqu'à 1400°C.

16. Procédé selon la revendication 15, **caractérisé en ce que** le matériau du substrat (6) est choisi parmi le groupe consistant en de la zircone, de l'alumine et du saphir.

17. Pièce (2) fabriquée via le procédé de fabrication selon l'une quelconque des revendications précédentes, **caractérisée en ce que** la pièce (2) est un composant décoré d'une pièce d'habillage horloger ou d'une pièce de bijouterie.

## Patentansprüche

1. Verfahren zur Herstellung eines Werkstücks (2), das wenigstens ein metallisiertes 3D-Motiv umfasst (4), das eine lokale Unterschicht aus Email (3) überragt; wobei das Verfahren die Schritte umfasst bestehend aus:
- Bereitstellen (10) eines Substrats (6), auf dem im Vorfeld ein oder mehrere 3D-Motiv(e) aus Email (3) ausgebildet sind;
- Ablagern (14) wenigstens einer Metallisierungsschicht (15) auf dem oder den Motiv(en) aus Email (3);
- Ablagern einer Harzschicht (17) auf der Metallisierungsschicht (15);
- selektives Bearbeiten (18) der Harzschicht (17), solcherart, dass lokale Harzteile (19) gebildet werden, die dem oder den 3D-Motiv(en) entsprechen oder komplementär dazu sind;
- Entfernen (20) der Teile (23) der Harzschicht, die komplementär zu dem oder den 3D-Motiv(en) sind, sowie der darunter liegenden Teile (21), die der Metallisierungsschicht (15) entsprechen; und
- Entfernen der verbleibenden Harzteile (19), solcherart, dass das oder die entsprechende(n) metallisierte(n) 3D-Motiv(e) (4) zum Erscheinen gebracht werden, wobei das oder jedes Motiv (4) aus dem Metallisierungsmaterial konstituiert ist, das auf einer lokalen Unterschicht aus Email (3) abgelagert ist.

2. Verfahren nach Anspruch 1, **dadurch gekennzeichnet, dass** das Harz (17) ein negatives oder positives photosensibles Harz ist, dadurch, dass die Teile (23) der Harzschicht, die komplementär zu dem oder den 3D-Motiv(en) sind, die nicht entwickelten oder entwickelten Teile der Harzschicht (17) sind, und dadurch, dass die verbleibenden Harzteile (19) die entwickelten oder nicht entwickelten Teile der Harzschicht (17) sind.

3. Verfahren nach Anspruch 1 oder 2, **dadurch gekennzeichnet, dass** das Email der lokalen Unterschicht aus Email (3) im Vorfeld gesintert wurde.

4. Verfahren nach einem der vorhergehenden Ansprüche, **dadurch gekennzeichnet, dass** es weiter vor dem Schritt (14) der Ablagerung einer Metallisierungsschicht (15) einen Schritt der Reinigung des oder der Motiv(e) aus Email (3) umfasst.

5. Verfahren nach einem der vorhergehenden Ansprüche, **dadurch gekennzeichnet, dass** die verbleibenden Harzteile (19) mittels eines Lösungsmittels entfernt werden.

6. Verfahren nach einem der vorhergehenden Ansprüche, **dadurch gekennzeichnet, dass** es weiter einen finalen Schritt des Reinigens des Werkstücks (2) umfasst.

7. Verfahren nach einem der vorhergehenden Ansprüche, **dadurch gekennzeichnet, dass** es sich bei dem Metallisierungsmaterial (15) um Chromnitrid, Zirkoniumoxynitrid, Gold oder Titan handelt.

8. Verfahren nach einem der vorhergehenden Ansprüche, **dadurch gekennzeichnet, dass** das photosensible Harz (17) ein photopolymerisierbares Harz ist wie ein photopolymerisierbares Epoxidharz, bevorzugt ein Harz auf der Basis von oktofunktionellem Epoxid SU-8.

9. Verfahren nach einem der Ansprüche 1 bis 7, **dadurch gekennzeichnet, dass** das nicht photosensible Harz (17) ein Harz auf der Basis von Epoxid ist.

10. Verfahren nach einem der Ansprüche 1 bis 8, **dadurch gekennzeichnet, dass** der Schritt (18) der selektiven Bearbeitung der photosensiblen Harzschicht (17) mittels einer UV-Lampe durchgeführt wird und eine initiale Phase des Auftragens einer Maske auf die Harzschicht (17) umfasst, wobei die Kontur der Maske dem oder den 3D-Motiv(en) entspricht.

11. Verfahren nach einem der Ansprüche 1 bis 7 und 9, **dadurch gekennzeichnet, dass** der Schritt (18) der selektiven Bearbeitung der nicht photosensiblen Harzschicht (17) mittels einer Laserabtragung durchgeführt wird.

12. Verfahren nach einem der vorhergehenden Ansprüche, **dadurch gekennzeichnet, dass** die Teile (21) der Metallisierungsschicht (15), die unter den Teilen (23) der Harzschicht liegen, die zu dem oder den 3D-Motiv(en) komplementär sind, durch Ätzen entfernt werden.

13. Verfahren nach einer der vorhergehenden Ansprüche, **dadurch gekennzeichnet, dass** am Ende des Schritts (14) der Ablagerung der Metallisierungsschicht (15) die Metallisierungsschicht (15) das oder die Motiv(e) aus Email (3) vollständig bedeckt.

14. Verfahren nach einem der vorhergehenden Ansprüche, **dadurch gekennzeichnet, dass** nach dem Schritt des Ablagerns der Harzschicht (17) das Harz (17) die Metallisierungsschicht (15) vollständig bedeckt.

15. Verfahren nach einem der vorhergehenden Ansprüche, **dadurch gekennzeichnet, dass** das Substrat (6) aus einem Material besteht, das in der Lage ist, Temperaturen von bis zu 1400 °C standzuhalten.

16. Verfahren nach Anspruch 15, **dadurch gekennzeichnet, dass** das Material des Substrats (6) aus der Gruppe ausgewählt ist bestehend aus Zirkoniumdioxid, Aluminiumoxid und Saphir.

17. Werkstück (2), das über das Herstellungsverfahren nach einem der vorhergehenden Ansprüche hergestellt wird, **dadurch gekennzeichnet, dass** das Werkstück (2) eine verzierte Komponente einer Uhrenverkleidung oder eines Schmuckstücks ist.

## Claims

1. A method for manufacturing a part (2) comprising at least one three-dimensional metallised pattern (4) overlying a local enamel underlayer (3); the method comprising the steps of:
- providing (10) a substrate (6) on which are formed, beforehand, in three dimensions, one or more enamel pattern(s) (3);
- depositing (14) at least one metallisation layer (15) on the enamel pattern(s) (3);
- depositing a resin layer (17) on the metallisation layer (15);
- selectively working (18) the resin layer (17), so as to locally form resin portions (19) corresponding to or complementary to the three-dimensional pattern(s);
- removing (20) the portions (23) of the resin layer complementary to the three-dimensional pattern(s), as well as the underlying portions (21) corresponding to the metallisation layer (15); and
- removing the remaining resin portions (19), so as to reveal the corresponding three-dimensional metallised pattern(s) (4), the or each pattern (4) being made of the metallisation material deposited on a local enamel underlayer (3).

2. The method according to claim 1, **characterised in that** the resin (17) is a negative or positive photosensitive resin, **in that** the portions (23) of the resin layer complementary to the three-dimensional pattern(s) are the undeveloped or developed portions of the resin layer (17), and **in that** the remaining resin portions (19) are the developed or undeveloped portions of the resin layer (17).

3. The method according to claim 1 or 2, **characterised in that** the enamel of the local enamel underlayer (3) has been sintered beforehand.

4. The method according to any one of the preceding claims, **characterised in that** it further comprises, before the step (14) of depositing a metallisation layer (15), a step of cleaning the enamel pattern(s) (3).

5. The method according to any one of the preceding claims, **characterised in that** the remaining resin portions (19) are removed by means of a solvent.

6. The method according to any one of the preceding claims, **characterised in that** it further comprises a final step of cleaning the part (2).

7. The method according to any one of the preceding claims, **characterised in that** the metallisation material (15) is chromium nitride, zirconium oxynitride, gold or titanium.

8. The method according to any one of the preceding claims, **characterised in that** the photosensitive resin (17) is a photopolymerisable resin such as a photopolymerisable epoxy resin, preferably an octofunctional epoxy resin SU-8.

9. The method according to any one of claims 1 to 7, **characterised in that** the non-photosensitive resin (17) is an epoxy-based resin.

10. The method according to any one of claims 1 to 8, **characterised in that** the step (18) of selectively working the photosensitive resin layer (17) is carried out by means of a UV lamp, and comprises an initial phase of applying a mask on the resin layer (17), the outline of the mask corresponding to said three-dimensional pattern(s).

11. The method according to any one of claims 1 to 7 and 9, **characterised in that** the step (18) of selectively working the non-photosensitive resin layer (17) is carried out by means of laser ablation.

12. The method according to any one of the preceding claims, **characterised in that** the portions (21) of the metallisation layer (15) underlying the portions (23) of the resin layer complementary to the three-dimensional pattern(s) are removed by chemical attack.

13. The method according to any one of the preceding claims, **characterised in that**, at the end of the step (14) of depositing the metallisation layer (15), the metallisation layer (15) completely covers the enamel pattern(s) (3).

14. The method according to any one of the preceding claims, **characterised in that**, at the end of the step of depositing the resin layer (17), the resin (17) completely covers the metallisation layer (15).

15. The method according to any one of the preceding claims, **characterised in that** the substrate (6) consists of a material capable of withstanding temperatures that can reach up to 1400°C.

16. The method according to claim 15, **characterised in that** the material of the substrate (6) is selected from the group consisting of zirconia, alumina and sapphire.

17. A part (2) manufactured using the manufacturing method according to any one of the preceding claims, **characterised in that** the part (2) is a component decorated with a timepiece external part or a piece of jewellery.
